# EUROPEAN PATENT SPECIFICATION

(11) **EP 1 426 458 B1**
(45) Date of publication and mention of the grant of the patent: **12.03.2008**
(21) Application number: 02406065.9
(22) Date of filing: 06.12.2002
(51) Int. Cl.: C22C 19/05, C30B 29/52, C30B 13/00

(54) **Method of locally depositing a MCrAlY coating**
Verfahren zur örtlichen Abscheidung einer MCrAlY - Beschichtung
Procédé pour le dépot local d'une couche de MCrAlY

(43) Date of publication of application: 09.06.2004
(73) Proprietor: Alstom Technology Ltd, 5400 Baden (CH)
(72) Inventor: Khan, Abdus Suttar Dr., 5408 Ennetbaden (CH); Duda, Thomas Dr., 5415 Nussbaumen (CH); Hoebel, Matthias Dr., 5210 Windisch (CH); Schnell, Alexander, 5408 Ennetbaden (CH)

(56) References cited:
- EP-A- 0 740 977
- EP-A- 1 001 055
- EP-A- 1 065 026
- EP-A- 1 070 769
- EP-A- 1 260 612
- US-A- 5 558 758
- US-B1- 6 274 193

## Description

### FIELD OF INVENTION

This invention relates according to claim 1 to a method of depositing a MCrAlY-coating.

### STATE OF THE ART

The turbine blades and vanes designed for use at high temperature are usually coated with environmentally resistant coatings. For example, MCrAlY overlay coatings are used for protection of turbine blades and vanes. MCrAlY protective overlay coatings are widely known in the prior art. They are a family of high temperature coatings, wherein M is selected from one or a combination of iron, nickel and cobalt. As an example US-A-3,528,861 or US-A-4,585,481 are disclosing such kind of oxidation resistant coatings. US-A-4, 152,223 as well discloses such method of coating and the coating itself. Besides the γ/β-MCrAlY-coating, there is another class of overlay MCrAlY coatings which are based on a γ/γ'-gamma/gamma prime-structure, which is for example disclosed in US-A-4,546,052 or US-A-4,973,445. The advantages of γ/γ'-coatings is that they have a negligible thermal expansion mismatch with alloy of the underlying turbine article and are likely to have a better thermal mechanical properties.

Among γ/γ'- and γ/β-coatings, the field of γ/β-coatings have been an active area of research and a series of patents has been issued. E.g. a NiCrAlY coating is described in US-A-3,754,903 and a CoCrAlY coating in US-A-3,676,085. US-A-4,346,137 discloses an improved high temperature fatigue resistance NiCoCrAlY coating. US-A-4,419,416, US-A-4,585,481, RE-32,121 and US-A-A-4, 743,514 describe MCrAlY coatings containing Si and Hf. US-A-4,313,760 discloses a superalloy coating composition with good oxidation, corrosion and fatigue resistance. Additional examples MCrAlY coatings are known from US-B1-6,280,857, US-B1-6,221,181, US-A-5,455,119, US-A-5,154,885, US-A-5, 035,958 or US-B1-6,207,297. They all deal primarily with improving the oxidation resistance of MCrAlY coatings.

Thermal barrier coatings are used to provide thermal insulation of the components in various types of engines e.g. in turbine engines. Furthermore, in the state of the art Thermal Barrier Coatings (TBC) are known from different patents. US-A-4,055,705, US-A-4,248,940, US-A-4,321,311 or US-A-4,676,994 disclose a TBC-coating for the use in the turbine blades and vanes. The ceramics used are yttria stabilized zirconia and applied by plasma spray (US-A-4, 055,705, US-A-4, 248,940) or by electron beam process (US-A-4, 321,311, US-A-4, 676,994) on top of the MCrAlY bond coat.

It is generally known in the industry that the coatings on turbine blades or vanes can fail by one or more of the following degradation modes. These are oxidation, corrosion, TMF (Thermal Mechanical Fatigue) and a combination of TMF and oxidation. Coatings failure in a turbine engine solely by oxidation is not a typical scenario. Further, in advanced turbine engines, incidences of corrosion are not common due to higher engine operating temperature and use of cleaner fuels. What is commonly observed is that the MCrAlY coatings are cracked by TMF. Subsequently the cracks allow oxygen diffuse or penetrate into the substrate. Since the substrate is not oxidation resistant the advancing oxygen (through the cracks) causes the oxidation of the underlying substrate and triggers the failure of the components. It is therefore important that the coatings be resistant to fatigue as well as oxidation since fatigue cracking appears to be one of the primary triggering mechanisms of the failure of the coatings.

One approach of improving the fatigue resistance of coatings is by modification of the composition of the coatings and secondly by the use of a thin coating or possibly a combination of both.

US-A-4,346,137 and US-A-4,758,480 described a method of improving the fatigue resistance of overlay coatings by a modification of composition. In US-A-4, 346,137, the platinum was added to MCrAlY coatings, which reduces the thermal expansion mismatch between the coatings and the substrate, hence also reduces the propensity of the coatings to cracking. This results in a significant improvement of the TMF life of the coatings. On the other hand, the US-A-4,758,480 discloses a class of protected coatings for superalloys in which the coating compositions are based on the composition of the underlying substrate. By tailoring the coatings to the substrate composition, diffusional stability results and other mechanical properties of the coating such as coefficient of thermal expansion and modulas, are brought closer to the substrate. The coatings thus obtained showed both increased oxidation and TMF resistance.

The increase of coating thickness decreases TMF life of coatings. The problem is then to find a method that allows a deposition of thin protective coatings on complex turbine airfoils. A literature search shows that the MCrAlY overlay coatings are generally deposited by plasma spray process (i.e. APS, VPS, LPPS or HVOF) or electron beam physical vapor deposition (EB-PVD) and sputtering. However, there are limitations of these processes; a) difficult or unable to deposit a thin coating, b) poor thickness control and c) a line of sight limitation. Since airfoils contain many complex contour surface i.e. airfoil to platform transition area, leading edge etc., the line of sight limitation present a difficulty in getting a good uniform coverage of coatings with thickness uniformity.

Interestingly, in a series of patents, US-A-5,558,758, US-A-5,824,205 and US-A-5,833,829 described the deposition of MCrAlY coatings by electroplated process. The process involves a deposition of the coating precursor, CrAlM2 powder in a M1 bath where M2 is one or more of Si, Ti, Hf, Ga, Nb, Mn, Pt and rare earth elements and M1 consists of Ni, Co, Fe alone or in combination. The as-deposited coating is heat-treated to obtain the final coating structure. The process provides a much better uniformity of coating distribution and coating of transition surfaces such as platforms to air foil with thickness integrity.

In a given airfoil the stress strain distribution and thermal-mechanical loading are different area to area. For example, some local area i.e. zone in an airfoil may be sensitive to oxidation or corrosion or thermal mechanical fatigue, or possibly a combination of one or more of degradation mode. Thus a local coating with appropriate set of properties could be potentially beneficial in increasing the lifetime of airfoils. Unfortunately, the plasma spray process generally used for manufacturing of coating is not suitable for local coating ― it has a line of sight limitation and cannot coat effectively many 'difficult to coat area' such as platform to airfoil transition area with good thickness control.

This inherent difficulty of line of sight limitation of plasma spray process is not shown by electroplated process.

There are references of local coating of turbine components or combustion components in the literature. For example, EP-B1-0 139 396 disclosed a process of local coating of turbine blade by plasma spraying of MCrAlY coatings. US-B1-6,435,830 and US-B1-6,270,318 wherein the underside of the platform is coated locally with a corrosion resistant coating. There are also examples of local coatings for repair or refurbish of components degraded by oxidation or corrosion. For example, US-B1-6,203,847 provided a method of repairing by first plating the affected areas with Pt or noble metals then aluminising the surfaces. Similarly US-B1-6,274,193 restored a protective coating in a local areas with a replacement aluminide coating.

### SUMMARY OF THE INVENTION

The aim of the present invention is to find a MCrAlY-bond or overlay coating with good oxidation and fatigue resistance according to the requirements on local areas of a gas turbine component. Another aim is to find a method of depositing a MCrAlY-coating on a turbine component with uniformity. Yet another aim of the invention is to deposit a thin MCrAlY-coating on a large industrial gas turbine blade or vane with a good thickness control of the deposited layer. Another aim is to deposit the MCrAlY-coatings on a component with a good microstructural conformity and thickness uniformity.

According to the invention a method of deposition a MCrAlY-coating was found described in the features of the claim 1.

With the present method MCrAlY-coatings are deposited on a component with a good microstructural conformity and metallurgical integrity.

According to the present invention individualized local or zone-coating 6 by using an electroplated method, a slurry process, a plasma spray, electrobeam physical vapor deposition, by sputtering or any other process used for coating of MCrAlY coating. It is noted that the cost of the application of a coating by a galvanic process is with advantage a third of a conventional plasma spray coating. In addition, the process of the invention has a thickness control of ±20 µm of the thickness of the deposited layer, where as conventional plasma spray coating processes have thickness scatters of ±75 µm or even more. Thus, a coating with a layer thickness in a range of 25-400 µm can be applied. A thinner coating increase the TMF life of the coating. The used electroplated process has no line of sight limitation and can coat complex contour surfaces without any difficulty.

The coating/masking step can be repeated at different local areas on the surface of the article before the conversion of the deposited MCrAlY-coating in single crystal form. The different areas can be coated with different MCrAlY-coatings. The MCrAlY-coatings are the selected according to the required properties in said areas in respect to one or a combination of oxidation, corrosion, thermal mechanical fatigue (TMF). As mask material wax and organic polymers are suitable.

Examples of coatings, that can be conveniently used for local coating and subsequent conversion to single crystal can be γ/γ' or γ/β-MCrAlY coatings. Examples of composition of γ/γ' are Ni-25Cr-6Al-0.4Y and Ni-Ni-16.5Cr-5.5AI-0.4Y and that of γ/β-MCrAlY is Ni-40Co-23Cr-8Al-1Ta-0.4Si-0.4Y, or known from the published patent application EP-A-1295970), or from the published patent application EP-A-1295969), both of which have the same applicant as the present application.

### BRIEF DESCRIPTION OF DRAWINGS

Preferred embodiments of the invention are illustrated in the accompanying drawings, in which
- **Fig. 1**: shows a gas turbine blade as an example and
- **Fig. 2**: shows a re-melting track on a coated single crystal substrate.

The drawing shows only parts important for the invention.

### DETAILED DESCRIPTION OF INVENTION

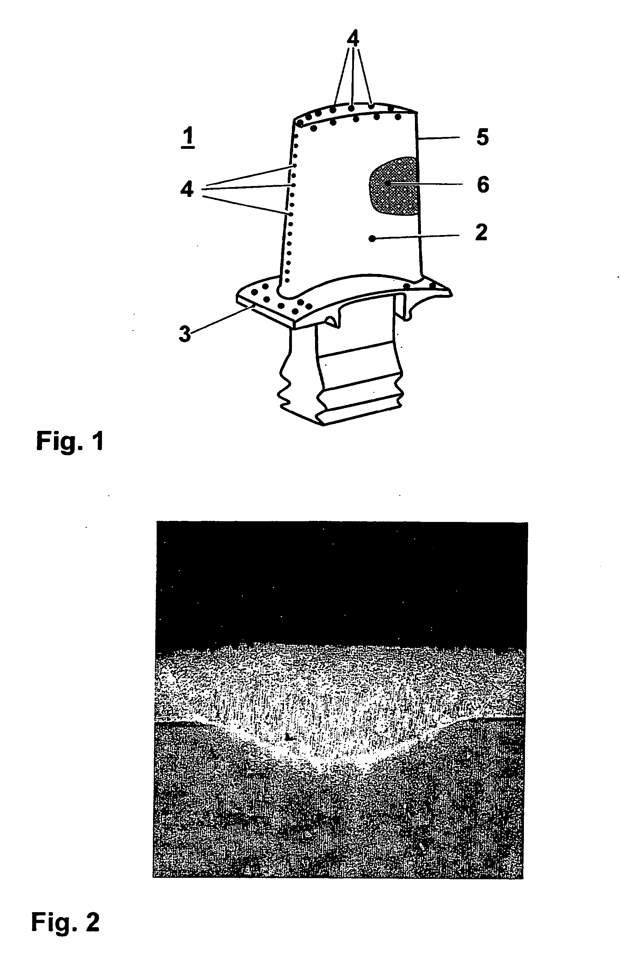

The present invention involves a method as set forth in claim 1 and is generally applicable to components that operate within environments characterised by relatively high temperature, and are therefore subjected to severe thermal stresses and thermal cycling. Notable examples of such components include the high and low pressure nozzles and blades, shrouds, combustor liners and augmentor hardware of gas turbine engines. Fig. 1 shows as an example such an article 1 as blades or vanes comprising a blade 2 against which hot combustion gases are directed during operation of the gas turbine engine, a cavity, not visible in Figure 1, and cooling holes 4, which are on the external surface 5 of the component 1 as well as on the platform 3 of the component. Through the cooling holes 4 cooling air is ducted during operation of the engine to cool the external surface 5. The external surface 5 is subjected to severe attack by oxidation, corrosion and erosion due to the hot combustion gases. In many cases the article 1 consists of a nickel or cobalt base super alloy such as disclosed, by way of an example, in US-A-5,759,301. In principle, the article 1 can be single crystal (SX) or directionally solidified (DS). While the advantages of this invention is described with reference to a turbine blade or vane as shown in Fig. 1, the invention is generally applicable to any component on which a coating system may be used to protect the component from its environment.

According to the present invention individualized local or zone-coating 6 of MCrAlY is by using an electroplated method, a slurry process, a plasma spray, electrobeam physical vapor deposition or by sputtering. With advantages, the TMF life of the electroplated coating 6 was at least 2 times higher than the life of the plasma sprayed coatings. It is noted that the cost of the application of a coating 6 by a galvanic process is with advantage a third of a conventional plasma spray coating. In addition, the process of the invention has a thickness control of ±20 µm of the thickness of the deposited layer, where as conventional plasma spray coating processes have thickness scatters of ±75 µm or even more. Thus, a coating with a layer thickness in a range of 25-400 µm can be applied. A thinner coating 6 increase the TMF life of the coating 6. The used electroplated process has no line of sight limitation and can coat complex contour surfaces without any difficulty. The target coatings 6 shall be selected from the MCrAlX family of coatings tailored for oxidation/corrosion or fatigue resistance according the requirements at the local zone. The coatings 6 shall be applied in steps. Initially the areas not be coated are masked and the target area is coated by the electroplated method.

Another previously masked area is coated, whereas the other areas is previously masked. To be able to coat the mask from the target area is removed and at the same time mask the previously coated area. The process of masking and coating of target areas are repeated as often as necessary. At completion, the surface will appear as if decorated with a series of 'patch coatings' each distinct from the other.

In a second step the deposited MCrAlY-coating 6 is converted into single crystal form epitaxial with the base material of the article 1 by laser remelting. The coating 6 step can be repeated at different local areas on the surface 5 of the article 1 before the conversion of the deposited MCrAlY-coating 6 in single crystal form.

The different areas can be coated with different MCrAlY-coatings 6. The MCrAlY-coatings are the selected according to the required properties in said areas in respect to one or a combination of oxidation, corrosion, thermal mechanical fatigue (TMF). One example of localized coating could be the TMF resistant coating on the platform/airfoil transition area of gas turbine blades and vanes and a highly oxidation resistant coating provided on the upper airfoil - the tip section.

The masks used are wax and organic polymers. These masks can be applied and removed easily and do not leave any residue or chemical impurity behind on the surface.

The method can be used as a repair process for a used MCrAlY-coating 6.

Examples of coatings, that can be conveniently used for local coating and subsequent conversion to single crystal can be γ/γ' or γ/β-MCrAlY coatings. Examples of composition of γ/γ' are Ni-25Cr-6Al-0.4Y and Ni-Ni-16.5Cr-5.5Al-0.4Y and that of γ/β-MCrAlY is Ni-40Co-23Cr-8Al-1Ta-0.4Si-0.4Y.

### Example of the invention

As an example of the invention as shown in Fig. 2 a re-melting track on a coated single crystal substrate. In this case a polycrystalline surface layer of about 0.3mm thickness has been remolten with a high power laser beam. The processing parameters were chosen such that the laser treatment resulted in an epitaxial solidification transforming the originally polycristalline surface layer into a single crystal coating. In Fig. 2 the matched orientation of the (fine) dendrites in the remolten area can be seen.

While our invention has been described by an example, it is apparent that other forms could be adopted by one skilled in the art. Accordingly, the scope of our invention is to be limited only by the attached claims.

### Reference numbers

- 1: Article
- 2: Blade
- 3: Platform
- 4: Cooling holes
- 5: External surface of article 1
- 6: Layer of MCrAlY

## Claims

1. A method of depositing a MCrAIY-coating (6) on the surface (5) of a single crystal (SX) or directionally solidified (DS) article (1), the method comprising the steps of
(a) coating the article (1) only at a local area with the MCrAIY-coating (6) and
(b) converting the deposited MCrAIY-coating in single crystal form epitaxial with the base material of the article (1)
wherein during step (a) the article (1) is coated locally by an electroplated method or alternatively
wherein during step (a) the article (1) is coated locally by a slurry process, a plasma spray, electron beam physical vapor deposition or by sputtering.

2. The method according to any of the claim 1, wherein during step (a) of the claim 1, the article (1) is coated locally with a γ/γ' or with a γ/β coating.

3. The method according to any of the claims 1 to 2, wherein the deposited MCrAlY-coating is converted in single crystal form by laser remelting.

4. The method according to any of the claims 1 to 3, wherein during step (a) of the method the areas not to be coated are masked with a masked material.

5. The method according to claim 4, wherein the areas not to be coated are masked with wax or organic polymers.

6. The method according to any of the claims 1 to 5, wherein the steps (a) and (b) are repeated at different local areas on the surface (5) of the article (1).

7. The method according to any of the claims 1 to 5, wherein the step (a) is repeated at different local areas on the surface (5) of the article (1) before the conversion of the deposited MCrAIY-coating in single crystal form.

8. The method according to claim 6 and 7, wherein different areas are coated with different MCrAlY-coatings, the MCrAIY-coatings are selected according to the required properties in said areas in respect to one or a combination of oxidation, corrosion, thermal mechanical fatigue (TMF).

9. The method according to any of the claim 1 to 8, wherein the method is used as a repair process for a used MCrAlY-coating (6).

10. The method according to any of the claims 1 to 9, wherein a gas turbine article (1) such as blades or vanes is coated.

## Patentansprüche

1. Verfahren zum Abscheiden eines MCrAlY-Überzugs (6) auf der Oberfläche (5) eines Einkristalls (SX) oder gerichtet erstarrten (DS) Artikels (1), wobei das Verfahren die folgenden Schritte umfasst:
(a) Beschichten des Artikels (1) nur an einem lokalen Bereich mit dem MCrAlY-Überzug (6) und
(b) Umwandeln des abgeschiedenen MCrAlY-Überzugs zur Einkristallform epitaxial mit dem Grundmaterial des Artikels (1),
wobei während des Schrittes (a) der Artikel (1) lokal durch ein Elektrobeschichtungsverfahren beschichtet wird, oder alternativ
wobei während des Schrittes (a) der Artikel (1) lokal durch ein Aufschlämmungsverfahren, ein Plasmasprühverfahren, durch physikalische Elektronenstrahl-Dampfabscheidung, durch Sputtern oder durch ein beliebiges anderes Verfahren , das zum Aufbringen eines MCrAlY-Überzuges benutzt wird, beschichtet wird.

2. Verfahren gemäß Anspruch 1, wobei während des Schrittes (a) des Anspruchs 1 der Artikel (1) lokal mit einem γ/γ'- oder mit einem γ/β-Überzug beschichtet wird.

3. Verfahren gemäß einem der Ansprüche 1 bis 2, wobei der abgeschiedene MCrAlY-Überzug zu einer Einkristallform mittels Laser-Umschmelzen umgewandelt wird.

4. Verfahren gemäß einem der Ansprüche 1 bis 3, wobei während des Schrittes (a) des Verfahrens die nicht zu beschichtenden Bereiche mit einem Maskierungsmaterial maskiert werden.

5. Verfahren gemäß Anspruch 4, wobei die nicht zu beschichtenden Bereiche mit Wachs oder organischen Polymeren maskiert werden.

6. Verfahren gemäß einem der Ansprüche 1 bis 5, wobei die Schritte (a) und (b) in unterschiedlichen lokalen Bereichen auf der Oberfläche (5) des Artikels (1) wiederholt werden.

7. Verfahren gemäß einem der Ansprüche 1 bis 5, wobei der Schritt (a) in unterschiedlichen lokalen Bereichen auf der Oberfläche (5) des Artikels (1) vor der Umwandlung des abgeschiedenen MCrAIY-Überzugs zur Einkristallform wiederholt wird.

8. Verfahren gemäß dem Anspruch 6 und 7, wobei unterschiedliche Bereiche mit unterschiedlichen MCrAlY-Überzügen beschichtet werden, wobei die MCrAlY-Überzüge gemäß den erforderlichen Eigenschaften in den Bereichen in Bezug auf einen von oder eine Kombination aus Oxidation, Korrosion, thermomechanischer Ermüdung (TMF) gewählt werden.

9. Verfahren gemäß einem der Ansprüche 1 bis 8, wobei das Verfahren als ein Wiederinstandsetzungsverfahren für einen gebrauchten MCrAlY-Überzug (6) verwendet wird.

10. Verfahren gemäß einem der Ansprüche 1 bis 9, wobei ein Gasturbinenartikel (1), wie Lauf- oder Leitschaufeln, beschichtet wird.

## Revendications

1. Procédé de dépôt d'un revêtement de MCrAlY (6) à la surface (5) d'un monocristal (SX) ou d'un objet (1) solidifié directionnellement (DS), le procédé comportant les étapes qui consistent à :
(a) revêtir l'objet (1) du revêtement (6) en MCrAlY uniquement sur une zone localisée et
(b) transformer le revêtement de MCrAlY déposé en monocristal par épitaxie avec le matériau de base de l'objet (1),
dans lequel au cours de l'étape (a), l'objet (1) est revêtu localement par un procédé de placage électrolytique ou en variante, pendant l'étape (a), l'objet (1) est revêtu localement par un procédé par suspension, une pulvérisation au plasma, un dépôt physique de vapeur à l'aide de faisceaux d'électrons ou par pulvérisation.

2. Procédé selon la revendication 1, dans lequel au cours de l'étape (a) de la revendication 1, l'objet (1) est revêtu localement par un revêtement γ/γ' ou un revêtement γ/β.

3. Procédé selon l'une quelconque des revendications 1 et 2, dans lequel le revêtement déposé de MCrAlY est converti en monocristal par refusion au laser.

4. Procédé selon l'une quelconque des revendications 1 à 3, dans lequel au cours de l'étape (a) du procédé, les zones qui ne doivent pas être revêtues sont masquées par un matériau de masquage.

5. Procédé selon la revendication 4, dans lequel les zones qui ne doivent pas être revêtues sont masquées par de la cire ou des polymères organiques.

6. Procédé selon l'une quelconque des revendications 1 à 5, dans lequel les étapes (a) et (b) sont répétées sur différentes zones locales de la surface (5) de l'objet (1).

7. Procédé selon l'une quelconque des revendications 1 à 5, dans lequel l'étape (a) est répétée sur différentes zones locales de la surface (5) de l'objet (1) avant la conversion du revêtement déposé de MCrAlY en monocristal.

8. Procédé selon les revendications 6 et 7, dans lequel différentes zones sont revêtues par différents revêtements de MCrAlY, le revêtement de MCrAlY étant sélectionné en fonction des propriétés requises dans lesdites zones par rapport à l'oxydation, la corrosion et/ou la fatigue thermomécanique (TMF).

9. Procédé selon l'une quelconque des revendications 1 à 8, dans lequel le procédé est utilisé comme procédé de réparation d'un revêtement (6) de MCrAlY usé.

10. Procédé selon l'une quelconque des revendications 1 à 9, dans lequel on revêt un élément (1) de turbine à gaz, par exemple des pales ou des aubes.
